# EUROPEAN PATENT APPLICATION

(11) **EP 4 414 431 A1**
(43) Date of publication of application: **14.08.2024**
(21) Application number: 22878524.2
(22) Date of filing: 04.10.2022
(51) Int. Cl.: C09D 11/037, C09D 11/322, C09D 11/52, H01G 4/12, H05K 3/28

(54) **INK, METHOD FOR MANUFACTURING INK, AND METHOD FOR MANUFACTURING MULTILAYER CERAMIC CAPACITOR**

(30) Priority: 06.10.2021 US 202163262177 P
(71) Applicant: Shoei Chemical Inc., Tokyo 163-0443 (JP)
(72) Inventor: BAYRAM, Ercan, Corvallis, Oregon 97333 (US); TYRELL, Paul, Corvallis, Oregon 97330 (US); BELL, LeAnn, Corvallis, Oregon 97330 (US); NOVET, Thomas, Corvallis, Oregon 97330 (US); BURNETT, Diane, Battle Ground, Washington 98604 (US)
(74) Representative: SSM Sandmair
(86) International application number: PCT/JP2022/037140
(87) International publication number: WO 2023/058656

(57) **Abstract**

An ink comprising: a metal nanoparticle with at least a portion of the surface of the metal nanoparticle coordinated by a hydroxycarboxylic acid ligand, the hydroxycarboxylic acid ligand comprising a carboxyl group and at least one hydroxyl group; and a solvent.

## Description

### [Technical field]

The present invention relates to an ink, a method for manufacturing an ink, and a method for manufacturing a multilayer ceramic capacitor.

This application claims priority based on U.S. Provisional Application No. 63/262,177 filed on October 6, 2021, and the contents described in the U.S. Provisional Application are incorporated herein in the entirety.

### [Background Art]

Multilayer ceramic capacitors (MLCC) may utilize metal layers formed from sintered metal nanoparticles. Metal nanoparticles also may be used in a variety of other contexts.

For example, Non-Patent Literature 1 describes a method for manufacturing nickel nanoparticles.

### [Citation List]

### [Non-Patent Literature]

[NPL 1] Sophie Carenco; et al., "Controlled Design of Size-Tunable Monodisperse Nickel Nanoparticles" Chemistry of Materials, vol.22 No.4, 2010, pp1340-1349

### [Summary of Invention]

### [Technical Problem]

As mentioned above, conductive layers of MLCCs may be formed from metal nanoparticles. One possible method for depositing the metal nanoparticles in a MLCC fabrication process is to inkjet print an ink comprising a metal nanoparticle onto a substrate, such as a ceramic tape. Such an ink also may be used for depositing metal nanoparticles in any other suitable context to form any other suitable product.

However, forming suitable metal nanoparticle inks for inkjet deposition poses various challenges. For example, many metal nanoparticles, in an as-synthesized form, are not dispersible and/or not stable in common inkjet solvent systems, such as propylene glycol butyl ether (PGBE). To help disperse the metal nanoparticles in a solvent, organic polymers and/or ligands can be introduced during metal nanoparticle synthesis as stabilizers. However, the use of such organic moieties may increase the viscosity of the ink to values not suitable for inkjet printing. Polymers and other stabilizers also can increase the organic carbon content of the metal nanoparticle to unsuitable levels. For example, during an MLCC fabrication process, a layer of metal nanoparticles may be sintered after deposition to bind the metal nanoparticles together as a film. Unsuitable levels of organic stabilizers on metal nanoparticles can result in the formation of an insulating carbonaceous mark from the sintering process. This can deteriorate the performance of the resulting capacitors.

Therefore, an object of the present invention is to provide an ink in which metal nanoparticles are dispersed and is suitable for inkjet printing.

### [Solution to Problem]

The ink according to the embodiment of the present invention is an ink comprising:
a metal nanoparticle with at least a portion of the surface of the metal nanoparticle coordinated by a hydroxycarboxylic acid ligand, the hydroxycarboxylic acid ligand comprising a carboxyl group and at least one hydroxyl group; and
a solvent.

The method for producing an ink to the embodiment of the present invention comprising:
synthesizing the metal nanoparticle;
after synthesizing the metal nanoparticle, performing a ligand exchange/introduction reaction to bind a hydroxycarboxylic acid ligand to at least a portion of the surface of the metal nanoparticle, the hydroxycarboxylic acid ligand comprising a carboxyl group and at least one hydroxyl group; and
dispersing the metal nanoparticle with at least a portion of the surface of the metal nanoparticle bound to the hydroxycarboxylic acid ligand in an ink solvent system to produce the ink comprising the metal nanoparticle.

The method for manufacturing a multilayer ceramic capacitor to the embodiment of the present invention is a method for manufacturing a multilayer ceramic capacitor having a plurality of layers, the method comprising:
obtaining an ink layer by inkjet printing an ink comprising a metal nanoparticle on at least a portion of a substrate;
sintering the ink layer to form an electrode layer;
wherein at least a portion of the surface of the metal nanoparticle is coordinated by a hydroxycarboxylic acid ligand, and
at least a portion of the layer is formed from the ink containing the metal nanoparticles.

### [Advantageous Effects of Invention]

According to the present invention, it is possible to provide an ink in which metal nanoparticles are dispersed and is suitable for inkjet printing.

### [Brief Description of Drawings]

[Fig. 1] FIG. 1 shows a flow diagram depicting an example method for producing an ink comprising a metal nanoparticle.
[Fig. 2A] FIG. 2A shows an example of a transmission electron microscopy (TEM) images of as-synthesized Ni nanoparticles.
[Fig. 2B] FIG. 2B shows a transmission electron microscopy (TEM) images of as-synthesized Ni nanoparticles.
[Fig. 2C] FIG. 2C shows a TEM image of Ni nanoparticles after ligand exchange/introduction.
[Fig. 3] FIG. 3 shows as-synthesized metal nanoparticles in propylene glycol butyl ether (PGBE).
[Fig. 4] FIG. 4 shows a graph depicting thermogravimetric analysis (TGA) results for as-synthesized metal nanoparticles.
[Fig. 5] FIG. 5 shows a graph depicting TGA results for example metal nanoparticles after ligand exchange/introduction.
[Fig. 6] FIG. 6 shows an image depicting an example dispersion of metal nanoparticles in PGBE after ligand exchange/introduction.
[Fig. 7A] FIG. 7A shows a microscopy image of an inkjet-printed metal nanoparticle film printed using an example ink prepared with ligand-exchanged metal nanoparticles.
[Fig. 7B] FIG. 7B shows a microscopy image of an inkjet-printed metal nanoparticle film printed using an example ink prepared with ligand-exchanged metal nanoparticles.
[Fig. 8] FIG. 8 shows a profilometer scan of the inkjet-printed film shown in FIGS. 7A and 7B.

### [Description of Embodiments]

Examples are disclosed that relate to inks comprising dispersions of metal nanoparticles and having viscosities suitably low for inkjet printing. One example provides an ink comprising metal nanoparticles with hydroxycarboxylic acid ligands coordinated to a portion of the metal nanoparticle surface, and a solvent. The hydroxycarboxylic acid ligand comprises at least one phenyl moiety, and the at least one phenyl moiety comprises at least one hydroxyl group.

Another example provides a method for producing an ink comprising a metal nanoparticle. The method comprises synthesizing a metal nanoparticle and after synthesizing the metal nanoparticle, performing a ligand exchange/introduction reaction to bind a hydroxycarboxylic acid ligand to at least a portion of the metal nanoparticle surface. The hydroxycarboxylic acid ligand comprises at least one phenyl moiety, and the at least one phenyl moiety comprises at least one hydroxyl group. The method further comprises dispersing the metal nanoparticle with at least a portion of the surface of the metal nanoparticle bound to the hydroxycarboxylic acid ligand in an ink solvent system to produce the ink comprising the metal nanoparticle.

This Summary is provided in order to introduce in simplified form a selection of concepts that are further described in the Detailed Description. The Summary is not intended to identify key features or essential features of the claimed subject matter, nor is it intended to be used to limit the scope of the claimed subject matter.

The ink of the present invention comprises metal nanoparticles. A hydroxycarboxylic acid ligand is coordinated to at least a portion of the metal nanoparticle surface.

Hydroxycarboxylic acid ligands comprises a carboxyl group and at least one hydroxyl group. When the hydroxycarboxylic acid ligand comprises at least one hydroxyl group, dispersibility can be imparted to the metal nanoparticles. Preferably, the hydroxycarboxylic acid ligand comprises at least one phenyl moiety, and preferably the phenyl moiety comprises at least one hydroxyl group. Such ligands may also be referred to as hydroxyphenylcarboxylic acids. Examples of hydroxycarboxylic acid ligands comprising at least one phenyl moiety, the phenyl moiety comprising at least one hydroxyl group, comprise gallic acid, 4-hydroxybenzoic acid, and 3-(4-hydroxyphenyl)propionic acid. By using a hydroxycarboxylic acid ligand as a ligand, the dispersibility of metal nanoparticles can be improved and dispersion stability can be imparted. In particular, by using a hydroxycarboxylic acid ligand comprising at least one phenyl moiety, and the phenyl moiety comprising at least one hydroxyl group, the dispersion stability of the metal nanoparticles can be further improved, and an ink suitable for inkjet printing can be obtained by dispersing metal nanoparticles in an ink solvent system.

Accordingly, examples are disclosed that relate to the manufacture of, the use of, and films formed with, an ink comprising a metal nanoparticle having hydroxycarboxylic acid ligand coordinated to at least a portion of the metal nanoparticle surface. In some examples, the hydroxycarboxylic acid ligand comprises at least one phenyl moiety on which a hydroxyl group is located. A metal nanoparticle bound by a hydroxycarboxylic acid ligand according to the disclosed examples may have high dispersibility in one or more inkjet printing solvent systems.

In the present invention, metal nanoparticles may comprise nickel nanoparticles. By comprising nickel nanoparticles, an ink suitable for forming a conductive layer of MLCC can be obtained. The diameter of the metal nanoparticles is preferably 2 nm to 80 nm. The diameter of the metal nanoparticles can be determined by calculating approximate circular equivalent diameters for at least 50 particles using a transmission electron microscope (TEM) image.

Further, an ink according to the present disclosure may have a suitably low viscosity for inkjet printing. According to the present disclosure a metal nanoparticle also may comprise a relatively low organic carbon content, thereby avoiding the formation of unsuitable amounts of carbon residue during sintering of a printed metal layer.

The ink of the present invention comprises a solvent (dispersion medium). The solvent may be a solvent commonly used in conductive pastes or a solvent commonly used in inkjet inks. Examples comprise alcohol-based, ether-based, ester-based, hydrocarbon-based solvents, and mixed solvents thereof. In particular, the inkjet ink preferably comprises propylene glycol butyl ether, propylene glycol methyl ether, terpineol, and dihydroterpineol acetate.

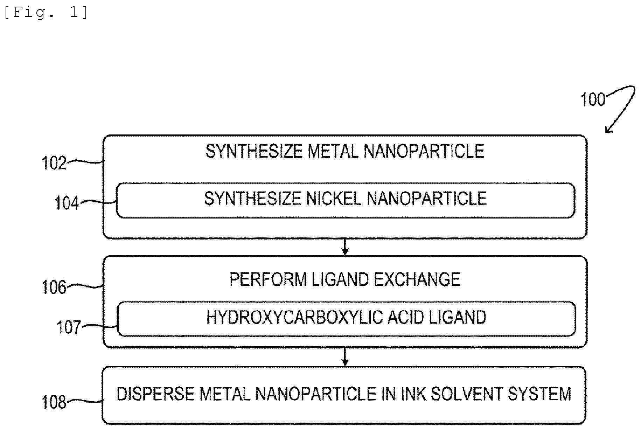

FIG. 1 shows a flow diagram depicting an example method 100 for producing an ink comprising a metal nanoparticle according to the present disclosure. At 102, the method 100 includes synthesizing the metal nanoparticle. In some examples, the metal nanoparticle may comprise a nickel nanoparticle, as indicated at 104. In other examples, the metal nanoparticle may comprise any other suitable metal.

Any suitable synthesis may be used to form the metal nanoparticle. In one example, a nickel nanoparticle was synthesized via decomposition of a Ni(acetylacetonate)₂ precursor with oleylamine and trioctylphosphine (TOP) at 220°C. More specifically, first, Ni(acetylacetonate)₂, oleylamine, and TOP were mixed, degassed at 100°C, and then heated at 220°C for 2 hours in an inert atmosphere.

A method for synthesizing such a Ni nanoparticle is described in more detail in non-patent literature (Chem. Mater. 2010, 22, 1340), except that the precursor amounts were modified to yield metal nanoparticles that were at least 35 nm in diameter in this disclosure. In some examples, metal nanoparticles were produced having diameters in the range of 40-50 nm. This synthesis results in a nickel nanoparticle bound by oleylamine and TOP ligands.

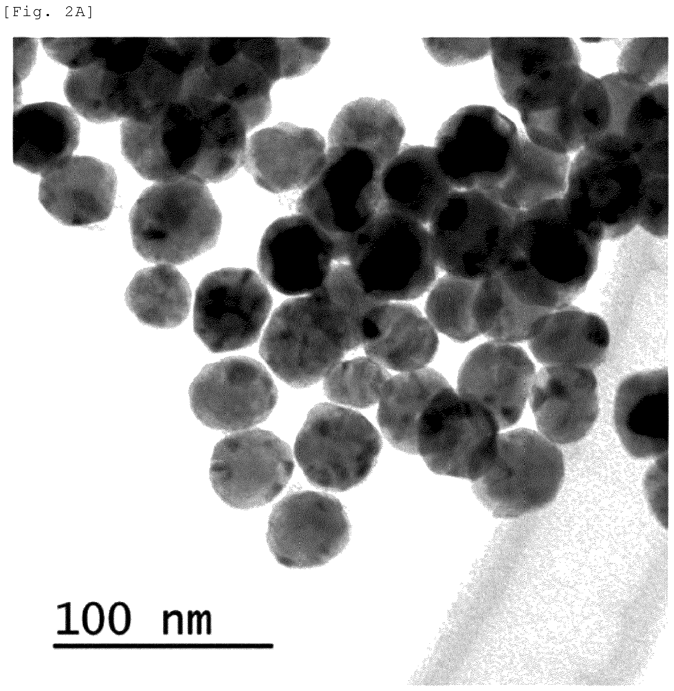

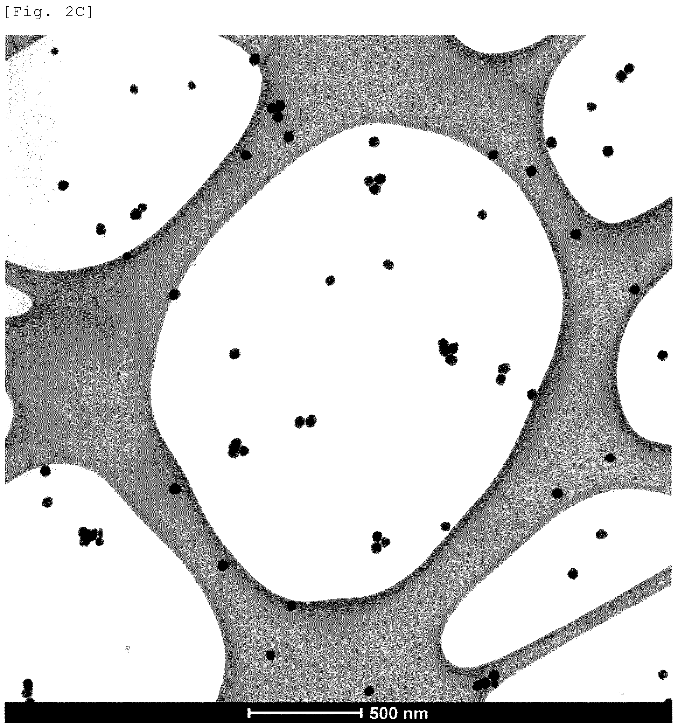

The obtained nickel nanoparticles were purified via centrifugation using acetone as an antisolvent. The purification yielded a black powder. FIGS. 2A-2B show TEM images of the as-synthesized nickel nanoparticles. TEM analysis confirmed ca. 45 nm monodisperse nickel nanoparticles. In contrast, FIG. 2C shows a TEM image of nickel nanoparticles after ligand exchange/introduction with 4-hydroxybenzoic acid. As described in more detail below, the dispersity of the nickel nanoparticles after ligand exchange/introduction is increased relative to the nickel nanoparticles of FIGS. 2A-2B. As a result, the nickel nanoparticles after ligand exchange/introduction are less prone to clustering by either aggregation or agglomeration on the TEM grid relative to the as-synthesized nickel nanoparticles of FIGS. 2A-2B.

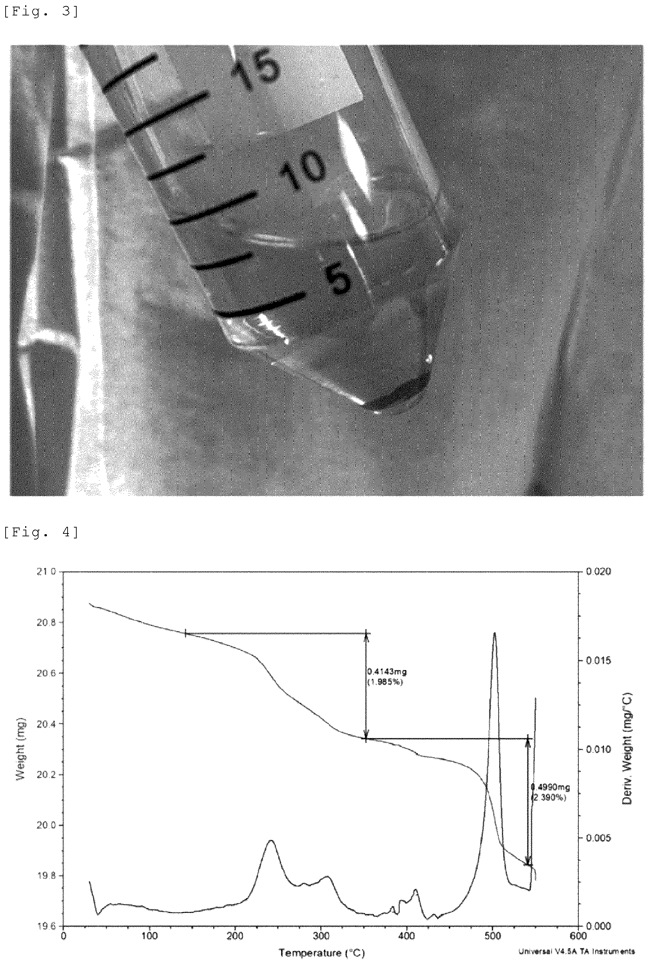

The as-obtained metal nanoparticles settle out of both polar and nonpolar solvents in a matter of minutes. Such metal nanoparticle solutions are not suitable for use as inkjet inks due to the instability of the dispersion. For example, the as-obtained nickel nanoparticles synthesized as described above were not dispersible in ethanol, and settled out in less than two minutes. The as obtained nickel nanoparticles were slightly soluble in common glycol ether ink vehicles, such as PGBE. A preparation of PGBE comprising 10 wt% of as-synthesized nickel nanoparticles was sonicated resulting in a somewhat dark colored solution with undissolved particles, but that completely sedimented in less than 30 minutes. FIG. 3 shows the state of the PGBE preparation containing 10 wt% of as-synthesized nickel nanoparticles 7 days after preparation.

When loaded with 30 wt% as-synthesized nickel nanoparticles, the PGBE formed an unstable paste having a viscosity of greater than 3,000 cP which was too high for inkjet printing,

Thus, to improve the stability and viscosity characteristics of an ink made from a metal nanoparticle, method 100 includes performing a partial ligand exchange/introduction reaction at 106 after synthesizing the metal nanoparticle. The ligand exchange reaction exchanges a ligand used during synthesis of the metal nanoparticle (e.g. oleylamine and/or TOP, as examples) with another ligand or binds to an available vacant surface of a metal nanoparticle. The ligand is selected to stabilize the metal nanoparticle in an ink solvent system and provide for a viscosity suitable for inkjet printing. Additionally, the ligand also may provide for a suitably low organic carbon content for a metal nanoparticle (e.g., less than 5 wt%), which helps reduce the formation of carbon residues during sintering compared to other organic additives.

The ligand may comprise any suitable compound. Some examples of suitable ligands include phosphines, amines, thiols, alcohols, and carboxylic acids, including phenolic acids. Some carboxylic acids may be particularly well-suited for use as ligands in a ligand exchange/introduction.

For example, carboxylic acids may not bind as strongly to the metal nanoparticle as other ligands, and thus may be easier to remove during sintering without affecting the electronic properties of the film formed by metal nanoparticles. In contrast, thiols may bind more strongly to metal nanoparticles, and sintering can result in the formation of a residual metal sulfide phase that affects the conductivity of the formed film. As a more specific example, a hydroxycarboxylic acid ligand may be used, as indicated in FIG. 1 at 107. Such a ligand may comprise at least one phenyl moiety having a substituent hydroxyl group. As described in more detail below, such ligands may provide suitable dispersibility in inkjet solvent systems and suitably low viscosity for inkjet printing while also providing sufficiently low organic carbon content to avoid leaving behind harmful amounts of residual carbon after sintering.

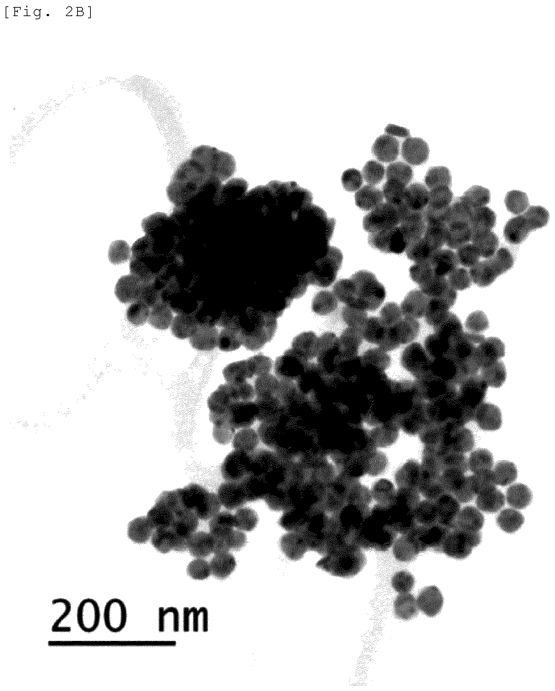

The purified as-produced nickel nanoparticles described above were taken in solid powder form and dispersed in ethanol, again forming a heterogeneous solution. Next, an excess amount of incoming ligand (hydroxycarboxylic acid ligand) was added and sonicated for 20 minutes. This was followed by stirring for 90 mins at room temperature at 800 RPM to further facilitate the ligand exchange/introduction to the nickel nanoparticle surface. The obtained ligand-exchanged/introduced nickel nanoparticles were purified and the excess ligands were removed by centrifugation with hexanes, yielding a black powder solid. As introduced above, FIG. 2C shows a TEM image of the ligand exchanged/introduced nickel nanoparticles. Compared to the as-synthesized nanoparticles shown in FIGS. 2A and 2B, the ligand-exchanged/introduced nickel nanoparticles have greater dispersity, and as a result, are more homogenously distributed in FIG. 2C.

### [Examples]

Table 1 shows the results of ligand exchange/introduction. 4-hydroxybenzoic acid, 3-(4-hydroxyphenyl)propionic acid, gallic acid, citric acid, and hexanoic acid were screened as ligands for ligand exchange/incorporation (Table 1).

When the hydroxycarboxylic acid ligands citric acid, 4-hydroxybenzoic acid, 3-(4-hydroxyphenyl)propionic acid and gallic acid were used, the PGBE preparation comprising 10 wt% of nickel nanoparticles after ligand exchange/introduction had good dispersion of the nickel nanoparticles. It was confirmed that dispersibility can be obtained by using a ligand having a polar group in PGBE, which is a polar solvent. However, in the dispersion comprising citric acid as a ligand, precipitation of nickel nanoparticles was observed in about one day. Gallic acid samples, which are hydroxycarboxylic acid ligands comprising at least one phenyl moiety, where the phenyl moiety is substituted with at least one hydroxyl group, had nickel nanoparticles sedimented in less than two days after dispersion preparation. For the 3-(4-hydroxyphenyl)propionic acid sample, some separation of the nickel nanoparticles and some sedimentation were observed after about one week after dispersion preparation. The 4-hydroxybenzoic acid sample provided the best dispersion and stability of the ligands tested (over a week). It has been found that the dispersion stability of nickel nanoparticles is further improved by using a hydroxycarboxylic acid ligand comprising at least one phenyl moiety, and the phenyl moiety comprising at least one hydroxyl group. Although the mechanism is not clear, it is presumably because the steric hindrance effect of the ligand on the nanoparticles was increased because the hydroxycarboxylic acid comprising the phenyl moiety.

In addition, when hexanoic acid is used as a ligand, the PGBE preparation comprising 10 wt% of nickel nanoparticles after ligand exchange/introduction was sonicated resulting in a somewhat dark colored solution with undissolved particles, but completely sedimented in less than 30 minutes. It was confirmed that dispersibility of PGBE, which is a polar solvent, was reduced by using hexanoic acid, which has a nonpolar tail, as a ligand. In addition, as described in more detail below, Ni films were successfully deposited by inkjet printing an ink comprising nickel nanoparticles with 4-hydroxybenzoic acid coordinated to at least a portion of the metal nanoparticle surface.

**[table 1]**

| | Ligand | Ligand ( wt% ) | Dispersibility | Occurrence of sedimentation |
|---|---|---|---|---|
| Comparative Example 1 | as-synthesized (oleylamine + TOP) | 4.4 | bad | < 30min |
| Example 1 | 4-hydroxybenzoic acid | 4.7 | good | > 7days |
| Example 2 | 3-(4-hydroxyphenyl) propionic acid | 4.6 | good | ca. 1week |
| Example 3 | Gallic acid | 4.5 | good | < 2days |
| Example 4 | Citric acid | 4.6 | good | ca. 1week |
| Comparative Example 2 | Hexanoic acid | 4.5 | bad | < 30min |

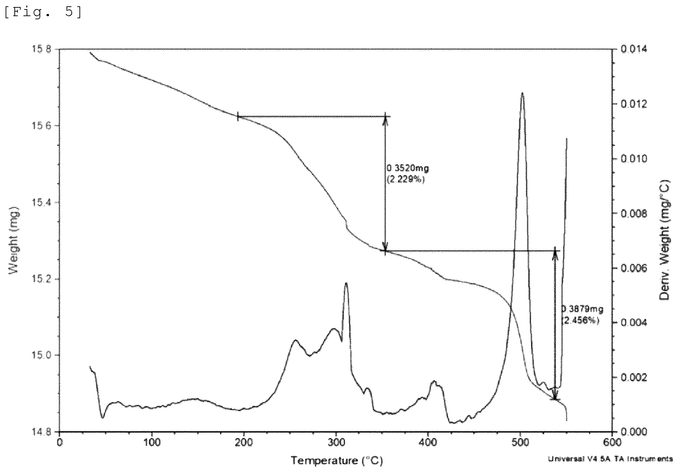

Using 4-hydroxybenzoic acid as the ligand, TGA of the ligand exchanged/introduced nickel nanoparticles showed less than 1% increase in organic carbon content with no detectable excess/un-coordinated/free ligand present. FIG. 4 shows one example TGA of the as-synthesized nickel nanoparticles. FIG. 5 shows one example TGA of the nickel nanoparticles after ligand exchange/introduction. The initial, gentle slope of each TGA graph is attributed to residual solvent leaving the sample. As described in more detail below, the first peak of the weight first derivative is attributed to oleylamine and its derivatives and is not differentiated from the ligand. The second peak of the weight first derivative is attributed to TOP.

In a separate investigation where oleylamine was used for the Ni nanoparticle synthesis, without TOP, the second peak of the weight first derivative did not appear. Accordingly, the first peak of the weight first derivative, around 200-300°C, was attributed to oleylamine and the second peak around 500°C was attributed to TOP. It is also suggested in Non-Patent Literature 1 (Chem. Mater. 2010, 22, 1340) and elsewhere that the signature of the bound oleylamine may also include oleylamine derivatives, which are expected to have a similar desorption temperature.

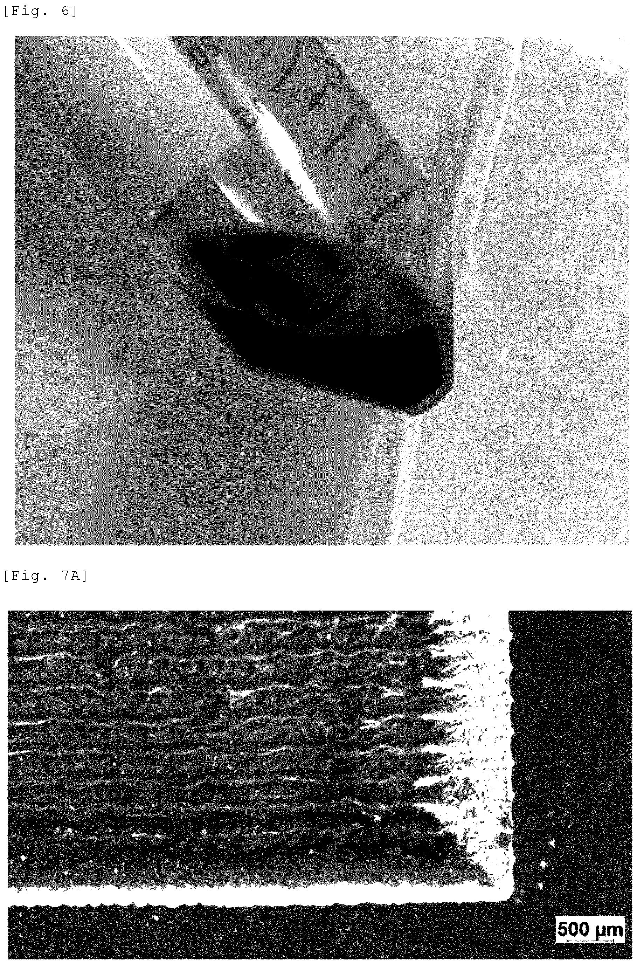

By dispersing the nickel nanoparticles after ligand exchange/introduction in PGBE to a concentration of about 10 wt% and subjecting them to ultrasonication, a homogeneous dispersion was obtained without particles settling. After > 7 days, the nickel nanoparticles were still stable and did not yield a clear supernatant with sedimented nickel nanoparticles. FIG. 6 shows the state of a PGBE preparation after > 7 days containing about 10 wt% of nickel nanoparticles after ligand
exchange/incorporation.

By introducing a ligand exchange/introduction reaction after the synthesis of nickel nanoparticles, nickel nanoparticles can be made dispersible and stable (>7 days) in a common ink solvent (PGBE) with high loadings (e.g., ≥ 30 wt%) while the viscosity of the ink is suitable for inkjet printing (e.g., approximately 8 cP). Further, the obtained ligand-exchanged/introduced nickel nanoparticles were found to have suitably low organic carbon content (e.g., less than 5 wt%) for a MLCC fabrication process.

Accordingly, the metal nanoparticle can be dispersed in an ink solvent system to produce an ink, as indicated at 108 of FIG. 1. As described above, preparations with PGBE as the ink solvent system with 30 wt% of as-obtained nickel nanoparticles and 30 wt% of nickel nanoparticles after ligand-exchanged/introduced yielded viscosities of >3000 cP and 8 cP, respectively (note here that PGBE has a native viscosity of 3 cP). As described above, the former viscosity is too large for this preparation to be inkjet printed, whereas the latter is suitable for inkjet printing. In other examples, an ink comprising a ligand-exchanged metal nanoparticle as disclosed can have any other suitable viscosity. Suitable viscosities include those within a range of between 7 cP and 20 cP.

Print coating properties were evaluated for inks using the ligand types and solvents listed in Table 2. The resolution was set to 1200 dpi, the ink ejection frequency was varied between 236 Hz and 4724 Hz, and the coating was performed on the printed glass substrate for an effective coating time of 3 minutes. In Comparative Example 1-1 using an ink containing as-synthesized nickel nanoparticles, nozzle out occurred frequently, especially in the region where the ink ejection frequency was low. When the nozzle was out, the print coatability was evaluated while cleaning the nozzle. On the other hand, in Examples 1-1 and 1-2, which used inks containing nickel nanoparticles that underwent ligand exchange/introduction using hydroxyphenylcarboxylic acid as a ligand, the number of nozzle outs was about one at most even if the ink ejection frequency was low.

**[table 2]**

| | Ink composition | | | | | Number of nozzleouts (resolution 1200 dpi) | | | | |
|---|---|---|---|---|---|---|---|---|---|---|
| | | | | | | Frequency Ink ejection frequency (Hz) | | | | |
| | saize of nickel nanoparticle | Nickel Content (wt%) | Ligand | Solvent | Viscosity | 4724 | 2362 | 1181 | 472 | 236 |
| Comparative Example 1-1 | 45 | 30 | oleylamine + TOP | TPO + PGMEA ( 3 : 1 ) | 22 | 0 | 0 | 0 | 3 | 16 |
| Example 1-1 | 45 | 30 | 4-hydroxybenzoic acid | TPO + PGMEA ( 3 : 1 ) | 18 | 0 | 0 | 0 | 0 | 0 |
| Example 1-2 | 45 | 30 | 4-hydroxybenzoic acid | TPO + PGBE ( 3 : 1 ) | 30 | 0 | 0 | 0 | 0 | 1 |

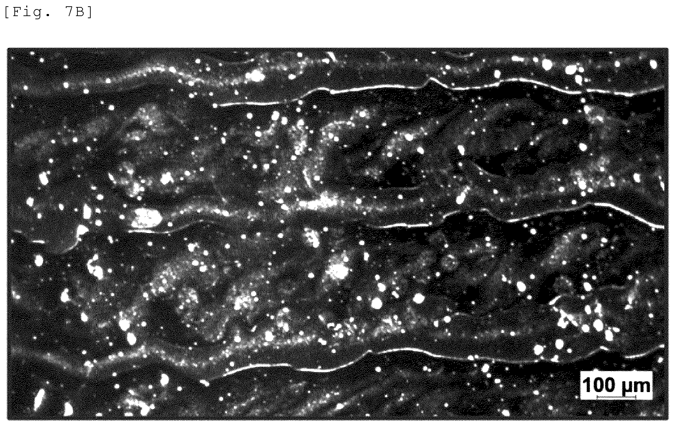

In one experiment, a film was prepared by inkjet printing the ligand-exchanged/introduced Ni nanoparticle dispersion onto a glass substrate. Very thin and smooth films were obtained with high nickel loading densities. FIG. 7A shows a microscopy image of the nickel nanoparticle film formed by inkjet-printing the ink comprising nickel nanoparticles after ligand exchange/introduction. FIG. 7B shows a close-up image of the nickel nanoparticle film of FIG. 7A. The ink used comprised 30 wt% of nickel nanoparticles after ligand exchange/introduction in which 4-hydroxybenzoic acid ligands were coordinated to at least a portion of the metal nanoparticle surface, in a PGBE ink solvent system with 1% polyvinyl butyral (PVB) additive (viscosity of 8 cP).

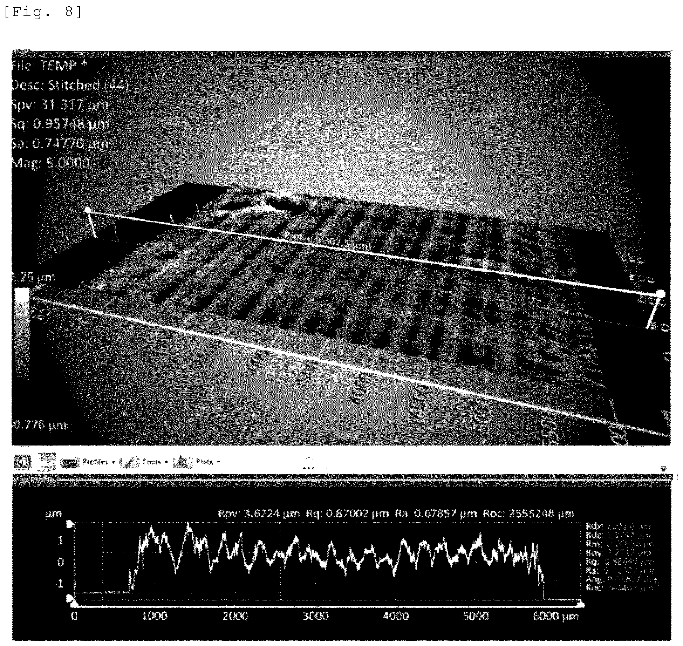

FIG. 8 shows a profilometer scan of the inkjet-printed nickel nanoparticle film of FIGS. 7A-7B. The nickel nanoparticle film formed by inkjet printing with nickel nanoparticles after ligand exchange/introduction was confirmed to have a nickel density of 0.84 mg/cm² and a green density of 4.9 g/cm³ and a film height of about 1.9 um by profilometry analysis. Inks containing ligand-exchanged/introduced metal nanoparticles for films formed by ink-jetting may be suitable for the manufacture of the electrode layer of MLCC's.

That is, a method for manufacturing a multilayer ceramic capacitor according to an embodiment of the present invention is a method for manufacturing a multilayer ceramic capacitor having a plurality of layers, the method comprising: obtaining an ink layer by inkjet printing an ink comprising a metal nanoparticle on at least a portion of a substrate; sintering the ink layer to form an electrode layer. The sintering temperature may be any temperature at which the metal nanoparticles are sintered and the resulting electrode layer has conductivity, and is preferably 200°C or higher, more preferably 300°C or higher, and still more preferably 400°C or higher. Moreover, a multilayer ceramic capacitor of a desired size can be obtained by stacking a plurality of substrates and cutting them appropriately as necessary. The step of stacking a plurality of substrates may be performed either before or after sintering the ink layer. This makes it possible to obtain a multilayer ceramic capacitor in which at least a portion of the layer is formed from the ink containing the metal nanoparticles.

Since the metal nanoparticles comprised in the ink are metal nanoparticles in which the hydroxycarboxylic acid ligand is coordinated to at least a portion of the surface of the metal nanoparticles, the electrode layer of the multilayer ceramic capacitor can be suitably formed by inkjet printing.

An ink, method for manufacturing an ink, and method for manufacturing a multilayer ceramic capacitor according to embodiments of the present invention comprise the following configurations.
(1) An ink comprising:
   a metal nanoparticle with at least a portion of the surface of the metal nanoparticle coordinated by a hydroxycarboxylic acid ligand, the hydroxycarboxylic acid ligand comprising a carboxyl group and at least one hydroxyl group; and
   a solvent.
(2) The ink as described in (1) hereinabove, wherein the hydroxycarboxylic acid ligand comprises at least one phenyl moiety, and the phenyl moiety comprises at least one hydroxyl group.
(3) The ink as described in (1) or (2) hereinabove, wherein the hydroxycarboxylic acid ligand is a hydroxyphenylcarboxylic acid ligand.
(4) The ink as described in any one of (1) to (3) hereinabove, wherein the metal nanoparticle comprises a nickel nanoparticle.
(5) The ink as described in any one of (1) to (4) hereinabove, wherein the metal nanoparticles have a diameter of 2 nm to 80 nm.
(6) The ink as described in any one of (1) to (5) hereinabove, wherein the hydroxycarboxylic acid ligand comprises at least one of 4-hydroxybenzoic acid or 3-(4-hydroxyphenyl)propionic acid.
(7) The ink as described in any one of (1) to (6) hereinabove, wherein the solvent comprises propylene glycol butyl ether.
(8) The ink as described in any one of (1) to (7) hereinabove, wherein the ink is disposed on a glass.
(9) The ink as described in any one of (1) to (8) hereinabove, wherein the metal nanoparticle comprises 5 wt% or less organic carbon content.
(10) The ink as described in any one of (1) to (9) hereinabove, wherein the ink comprises a viscosity of between 7 cP and 20 cP.
(11) The ink as described in any one of (1) to (10) hereinabove, wherein the ink comprises 30 wt% or more of metal nanoparticle loading.
(12) A method for producing an ink comprising a metal nanoparticle, the method comprising:
   synthesizing the metal nanoparticle;
   after synthesizing the metal nanoparticle, performing a ligand exchange/introduction reaction to bind a hydroxycarboxylic acid ligand to at least a portion of the surface of the metal nanoparticle, the hydroxycarboxylic acid ligand comprising a carboxyl group and at least one hydroxyl group; and
   dispersing the metal nanoparticle with at least a portion of the surface of the metal nanoparticle bound to the hydroxycarboxylic acid ligand in an ink solvent system to produce the ink comprising the metal nanoparticle.
(13) The method for producing an ink as described in (12) hereinabove, wherein the hydroxycarboxylic acid ligand comprises at least one phenyl moiety, and the phenyl moiety comprises at least one hydroxyl group.
(14) The method for producing an ink as described in (12) or (13) hereinabove, wherein the hydroxycarboxylic acid ligand is a hydroxyphenylcarboxylic acid ligand.
(15) The method for producing an ink as described in any one of (12) to (14) hereinabove, wherein synthesizing the metal nanoparticle comprises synthesizing a nickel nanoparticle.
(16) The method for producing an ink as described in any one of (12) to (15) hereinabove, wherein the metal nanoparticles have a diameter of 2 nm to 80 nm.
(17) The method for producing an ink as described in any one of (12) to (16) hereinabove, wherein the performing a ligand exchange/introduction reaction comprises binding at least one of 4-hydroxybenzoic acid or 3-(4-hydroxyphenyl)propionic acid to at least a portion of the surface of the metal nanoparticle.
(18) The method for producing an ink as described in any one of (12) to (17) hereinabove, wherein dispersing the metal nanoparticle in the ink solvent system comprises dispersing the metal nanoparticle in a solvent system comprising propylene glycol butyl ether.
(19) The method for producing an ink as described in any one of (12) to (18) hereinabove, wherein dispersing the metal nanoparticle in the ink solvent system comprises dispersing sufficient metal nanoparticle to provide a viscosity of between 7 cp and 20 cP.
(20) The method for producing an ink as described in any one of (12) to (19) hereinabove, wherein dispersing the metal nanoparticle in the ink solvent system comprises dispersing 30 wt% or more metal nanoparticle in the ink solvent system.
(21) A method for manufacturing a multilayer ceramic capacitor having a plurality of layers, the method comprising:
   obtaining an ink layer by inkjet printing an ink comprising a metal nanoparticle on at least a portion of a substrate;
   sintering the ink layer to form an electrode layer;
   wherein at least a portion of the surface of the metal nanoparticle is coordinated by a hydroxycarboxylic acid ligand, and
   at least a portion of the layer is formed from the ink containing the metal nanoparticles.

It will be understood that the configurations and methods described herein are provided by way of example, and that these examples are not to be considered in a limiting sense because numerous variations, extensions, and omissions are also envisaged. Any of the various acts of an above method may be performed in the sequence illustrated, in other sequences, in parallel, or omitted. The subject matter of the present disclosure includes all novel and non-obvious combinations and subcombinations of the various configurations, methods, properties, and other features disclosed herein, as well as any and all equivalents thereof.

## Claims

1. An ink comprising:
a metal nanoparticle with at least a portion of the surface of the metal nanoparticle coordinated by a hydroxycarboxylic acid ligand, the hydroxycarboxylic acid ligand comprising a carboxyl group and at least one hydroxyl group; and
a solvent.

2. The ink according to claim 1, wherein the hydroxycarboxylic acid ligand comprises at least one phenyl moiety, and the phenyl moiety comprises at least one hydroxyl group.

3. The ink according to claim 1 or 2, wherein the hydroxycarboxylic acid ligand is a hydroxyphenylcarboxylic acid ligand.

4. The ink according to any one of claims 1 to 3, wherein the metal nanoparticle comprises a nickel nanoparticle.

5. The ink according to any one of claims 1 to 4, wherein the metal nanoparticles have a diameter of 2 nm to 80 nm.

6. The ink according to any one of claims 1 to 5, wherein the hydroxycarboxylic acid ligand comprises at least one of 4-hydroxybenzoic acid or 3-(4-hydroxyphenyl)propionic acid.

7. The ink according to any one of claims 1 to 6, wherein the solvent comprises propylene glycol butyl ether.

8. The ink according to any one of claims 1 to 7, wherein the ink is disposed on a glass.

9. The ink according to any one of claims 1 to 8, wherein the metal nanoparticle comprises 5 wt% or less organic carbon content.

10. The ink according to any one of claims 1 to 9, wherein the ink comprises a viscosity of between 7 cP and 20 cP.

11. The ink according to any one of claims 1 to 10,
wherein the ink comprises 30 wt% or more of metal nanoparticle loading.

12. A method for producing an ink comprising a metal nanoparticle, the method comprising:
synthesizing the metal nanoparticle;
after synthesizing the metal nanoparticle, performing a ligand exchange/introduction reaction to bind a hydroxycarboxylic acid ligand to at least a portion of the surface of the metal nanoparticle, the hydroxycarboxylic acid ligand comprising a carboxyl group and at least one hydroxyl group; and
dispersing the metal nanoparticle with at least a portion of the surface of the metal nanoparticle bound to the hydroxycarboxylic acid ligand in an ink solvent system to produce the ink comprising the metal nanoparticle.

13. The method for producing an ink according to claim 12, wherein the hydroxycarboxylic acid ligand comprises at least one phenyl moiety, and the phenyl moiety comprises at least one hydroxyl group.

14. The method for producing an ink according to claim 12 or 13, wherein the hydroxycarboxylic acid ligand is a hydroxyphenylcarboxylic acid ligand.

15. The method for producing an ink according to any one of claims 12 to 14, wherein synthesizing the metal nanoparticle comprises synthesizing a nickel nanoparticle.

16. The method for producing an ink according to any one of claims 12 to 15, wherein the metal nanoparticles have a diameter of 2 nm to 80 nm.

17. The method for producing an ink according to any one of claims 12 to 16, wherein the performing a ligand exchange/introduction reaction comprises binding at least one of 4-hydroxybenzoic acid or 3-(4-hydroxyphenyl)propionic acid to at least a portion of the surface of the metal nanoparticle.

18. The method for producing an ink according to any one of claims 12 to 17, wherein dispersing the metal nanoparticle in the ink solvent system comprises dispersing the metal nanoparticle in a solvent system comprising propylene glycol butyl ether.

19. The method for producing an ink according to any one of claims 12 to 18, wherein dispersing the metal nanoparticle in the ink solvent system comprises dispersing sufficient metal nanoparticle to provide a viscosity of between 7 cp and 20 cP.

20. The method for producing an ink according to any one of claims 12 to 19, wherein dispersing the metal nanoparticle in the ink solvent system comprises dispersing 30 wt% or more metal nanoparticle in the ink solvent system.

21. A method for manufacturing a multilayer ceramic capacitor having a plurality of layers, the method comprising:
obtaining an ink layer by inkjet printing an ink comprising a metal nanoparticle on at least a portion of a substrate;
sintering the ink layer to form an electrode layer;
wherein at least a portion of the surface of the metal nanoparticle is coordinated by a hydroxycarboxylic acid ligand, and
at least a portion of the layer is formed from the ink containing the metal nanoparticles.
